# EUROPÄISCHE PATENTANMELDUNG

(11) **EP 0 592 972 A2**
(43) Veröffentlichungstag der Anmeldung: **20.04.1994**
(21) Anmeldenummer: 93116392.7
(22) Anmeldetag: 09.10.1993
(51) Int. Cl.: G03F 7/085, H01L 21/312

(54) **Mit einem Resist beschichtete Metall- oder Halbleitersubstrate und Verfahren zur Erzielung einer stabilen Resist-Substrat-Haftung**

(30) Priorität: 13.10.1992 DE 4234423
(71) Anmelder: INSTITUT FÜR MIKROTECHNIK MAINZ GmbH, D-55129 Mainz-Hechtsheim (DE)
(72) Erfinder: Schenck, Rainer, Dr., D-65451 Kelsterbach (DE); Abraham,. Michael, Dr., D-55129 Mainz (DE); Ehrfeld, Wolfgang, Prof., D-55116 Mainz (DE)
(74) Vertreter: Fuchs, Luderschmidt & Partner Patentanwälte

(57) **Zusammenfassung**

2.1 Für die Herstellung von Formen für mikromechanische Strukturen mittels Röntgentiefenlithographie sollen mit einem festhaftenden Resist beschichtete Substrate aus Metallen oder Halbleitern zur Verfügung gestellt werden.

2.2 Das für die Beschichtung mit dem Resist vorgesehene Substrat wird vor der Beschichtung mit dem Resist zunächst in einer Lösung einer zur Selbstorganisation befähigten linearen organischen Verbindung mit zwei endständigen funktionellen Gruppen behandelt. Zwischen Substrat und Resist wird so eine monomolekularen Schicht aus Molekülen erhalten, die sowohl über die Bindung an das Substrat als auch an den Resist als Haftvermittlerschicht dient.

2.3 Resist-beschichtete Substrate für die Röntgentiefenlithographie und ihre Herstellung.

## Beschreibung

Bei der Herstellung von Formen für mikromechanische Strukturen mittels Röntgentiefenlithographie (LIGA-Technik) werden aus einem strahlungsempfindlichen Kunststoff (Resist) mit energiereicher Strahlung mikrometerfeine Strukturen extrem großer Tiefenschärfe herausgearbeitet. Der Resist wird hierzu auf eine leitfähige Grundplatte (Substrat) aufpolymerisiert.

Die Bestrahlung der in der Regel mehrere 100 µm dicken Schicht aus Kunststoff erfolgt mittels extrem energiereicher paralleler Röntgenstrahlung (Synchrotonstrahlung) durch eine üblicherweise aus Gold bestehende Maske hindurch. Um ein durch die Maske definiertes Muster auf die Resistschicht zu übertragen, findet in den durch die Maske festgelegten bestrahlten Bereichen des Resists eine photochemische Umwandlung statt, wodurch die Löslichkeit der belichteten Bereiche erhöht (oder manchmal auch erniedrigt) wird. Die bestrahlten Bereiche des Resists werden danach mittels eines speziellen Entwicklungsprozeßes mit einem Lösungsmittel selektiv entfernt. Zurück bleibt eine reliefartige Struktur der unbestrahlten Resistbereiche auf dem Substrat, deren Hohlräume mittels galvanischer Verfahren aufgefüllt werden. Die dann nach Entfernung der übriggebliebenen Resiststruktur vorliegende komplementäre Mikrostruktur aus dem durch die galvanische Füllung entstandenen Metall kann dann direkt das erwünschte Endprodukt darstellen oder eine Form für einen Mikrospritzguß, wobei letztere dann das endgültige Produkt aufbaut.

Die Art der Verwendung des Resists sowie die an die Genauigkeit der daraus zu formenden mikromechanischen Strukturen zu stellenden Anforderungen bedingen ihrerseits hohe Anforderungen an die chemischen und physikalischen Eigenschaften des Resists: Das Polymer muß empfindlich auf die Röntgenstrahlung mit signifikanten Unterschieden zwischen bestrahltem und nicht bestrahltem Material reagieren, dabei aber hohen mechanischen und thermischen Belastungen standhalten. Darüber hinaus ist eine hohe Strukturgenauigkeit bei relativ hoher Schichtdicke (bis ca. 1000 µm) mit einem hohen Verhältnis von Bauteilhöhe zu lateraler Dimension (Aspektverhältnis) in der reliefartigen Struktur des entwickelten Resists erforderlich. Eine entsprechende Verarbeitungssicherheit beim galvanischen Füllen kann aber nur dann aufrecht erhalten werden, wenn die Strukturteile der aus dem Resist nach Bestrahlung und Entwicklung gebildeten Reliefstruktur fest auf dem Substrat haften und wahrend der Ausbildung der metallischen Mikrostruktur ortsfest fixiert bleiben.

Da das mit dem Resist beschichtete Substrat für die Galvanoformung eine gewisse Leitfähigkeit aufweisen muß, werden hierfür gewöhnlich Grundplatten aus Metall oder Halbleitern verwendet. Eine für das LIGA-Verfahren erforderliche hohe Haftung zwischen Resist und Substrat ist jedoch wegen der äußerst unterschiedlichen chemischen Struktur der verwendeten Materialien und der beim Verfahren auftretenden hohen mechanischen Spannungen, verursacht durch die unterschiedlichen Ausdehnungskoeffizienten von Metall und Polymer, äußerst problematisch.

Ohne Hafthilfsmittel löst sich die Resistschicht auf glatten, insbesondere polierten Substratoberflächen nach der mit erheblicher Erwärmung verbundenen Bestrahlung spontan von der Oberfläche ab. Aus diesem Grunde wurden die Oberflächen geläppt oder sandgestrahlt, um mit der dann erhaltenen Oberflächenrauhigkeit eine gewisse formschlüssige Verbindung mit dem Resist während der Quervernetzung des Polymers auf der Substratoberfläche zu erzielen. Eine weitere Methode, die Oberfläche aufzurauhen, bestand darin, zunächst eine Titanschicht von ca. 2 µm Dicke aufzutragen und diese Schicht dann in einem weiteren Behandlungsschritt, z.B. mit H₂O₂ zu oxidieren. Da eine solche Oxidation mit einem Ätzabtrag verbunden ist, bildet sich dabei ebenfalls eine rauhe Oberfläche aus, die sogar noch Löcher aufweisen kann. Auch hier besteht die Bindung zum nachfolgend aufgebrachten Resistmaterial in einer mehr oder weniger mechanischen Verklammerung, vermittelt über die rauhe Oberfläche des Substrats. Ein Nachteil einer solchen "Haftverbesserung" besteht jedoch in dem großen Arbeitsaufwand bei einer relativ nur bescheidenen Verbesserung des Haftverhaltens. Die Titanschicht muß umständlich aufgesputtert werden und in einem zweiten Arbeitsgang, dem Oxidationsschritt, aufgerauht werden. Darüber hinaus erwies sich auch die Reproduzierbarkeit bei Herstellung von Titanoxid-Schichten als problematisch, so daß teilweise eine Ablösung des aufgebrachten Resistmaterials erfolgte.

Eine weitere Verbesserung der Resisthaftung erbrachte eine chemische Anbindung des Resistmaterials auf der Substratoberfläche. Zu diesem Zwecke setzte man dem aus dem Resistmaterial bestehenden Gießharz, gewöhnlich bestehend aus einer Lösung von PMMA Poly(methylmethacrylat) in Methylmethacrylat vor der Quervernetzung auf der Substratoberfläche eine interne Haftvermittlersubstanz zu. Letztere weist eine funktionelle Gruppe auf, welche in der Lage ist, mit der Substratoberfläche eine chemische Verbindung einzugehen.

Der Haftmechanismus über einen solchen Haftvermittler setzt allerdings voraus, daß die Oberfläche der Substrate bei der Lagerung an Luft je nach Reaktionsfähigkeit des Substrats oxidiert und in der obersten Molekülschicht durch Adsorption von Wasser hydrolysiert ist, so daß die reaktive Gruppe des Haftvermittlers mit den an der Oberfläche des Substrats gebildeten OH-Gruppen reagieren kann. Die Anhaftung kann dabei über Dipol-Dipol-Wechselwirkung, H-Brückenbildung, Van-der-Waals'sche Kräfte oder eine Atombindung geschehen.

Eine bevorzugte funktionelle Gruppe, welche mit den Hydroxylgruppen auf der Oberfläche von metallischen oder Halbleitersubstraten reagiert, ist die Trimethoxysilyl-Gruppe. Für interne Haftvermittler als besonders geeignet erwiesen sich Verbindungen wie z.B. Methacryloyloxypropyltrimethoxysilan (MEMO) oder Hydroxyethylmethacrylphosphat (HEMA-Phosphat).

Der dem MEMO zugrunde liegende Verknüpfungsmechanismus beruht zunächst auf einer Hydrolyse des Silans zum Silanol, wobei Methanol abgespalten wird. Die resultierenden Silanolgruppen reagieren über eine Kondensationsreaktion mit der hydrolysierten Oxidschicht der Substratoberfläche zu einer Siloxanverbindung. Da gleichzeitig eine Autokondensation zweier Silanolgruppen von benachbarten Molekülen stattfinden kann, bildet sich ein an die Substratoberfläche gebundenes Netzwerk aus Siloxan aus.

Durch eine reaktive C = C-Doppelbindung im organischen Rest kann MEMO zusätzlich in die Polymermatrix eingebaut werden. Die aus der Polymermatrix in Richtung auf das Substrat hervorragenden reaktiven Trimethoxysilyl-Gruppen vermitteln dann die chemische Bindung mit den Oberflächenhydroxylgruppen des Substrats. Beim HEMA-Phosphat bildet sich mit der Phosphatgruppe an der Substratoberfläche eine ionische Bindung oder gar eine Komplexbindung aus. Der Einbau in die Polymermatrix erfolgt analog wie bei MEMO. Es zeigte sich, daß die Haftung von HEMA-Phosphat insgesamt etwas fester als die von MEMO war.

Trotz zufriedenstellender Haftung an die metallische Substratoberfläche wiesen diese internen Haftvermittler grundsätzliche Nachteile auf, welche insbesondere bei der Bestrahlung des aufgetragenen Resists zutage kamen. Daß das Haftvermittlermaterial über das gesamte Volumen des Resistmaterials verteilt vorliegt, beeinflußt es dessen Strahlungsempfindlichkeit erheblich. Das schwere Siliciumatom, welches dann mehr oder weniger gleichverteilt im Volumen des Resistmaterials vorliegt, absorbiert relativ viel Röntgenstrahlung, wodurch sich der Unterschied zwischen belichtetem und unbelichtetem Material zunehmend vermindert, worunter nicht zuletzt die Strukturgenaugigkeit der zu erstellenden Mikroform leidet.

Darüber hinaus ergab sich für die untersuchten haftvermittelnden Substanzen auf Edelmetallen, wie z.B. Gold, Silber oder Kupfer, keine Haftung, da diese auf ihrer Oberfläche keine durch einen Oxidationsschritt iniziierte Hydroxylgruppen ausbilden können, das heißt interne Haftvermittler können nur auf reaktiven Oberflächen wirksam sein.

Aus der DE 38 08 952 sind Haftschichten für Druckplatten bekannt. Dabei wird der Schichtträger, eine nicht leitfähige Polyesterfolie, durch Ätzen aufgerauht und anschließend eine nicht leitfähige Haftschicht mit einer Dicke von 20 µm aufgebracht. Auf solchermaßen vorbehandelten Substraten ist jedoch keine galvanische Abformung möglich, wie sie in LIGA-Verfahren notwendig ist.

Der Erfindung liegt daher die Aufgabe zugrunde, zur Herstellung von Formen für mikromechanische Strukturen mittels Röntgentiefenlithographie geeignete Schichtkombinationen zur Verfügung zu stellen, wobei ein mittels Strahlung zu strukturierender strahlungsempfindlicher Kunststoff über den gesamten Prozeß der röntgenlithographischen Bildung der Mikrostrukturform auf einem leitfähigen, metallischen oder Halbleitersubstrat fest haften bleibt. Die Oberfläche des Substrats soll dabei durch keine abrasive Vorbehandlung aufgerauht sein. Darüber hinaus sollen als Substrate sowohl Edelmetalle, wie z.B. Gold, Silber oder Kupfer, als auch unedle Metalle und Halbleiter eingesetzt werden können. Der Erfindung liegt ferner die Aufgabe zugrunde, ein Verfahren bereitzustellen, mit welchem der Resist festhaftend auf eine leitende oder halbleitende Grundplatte aufgetragen werden kann, wobei das Verfahren andererseits aber auf einfache Weise durchzuführen ist.

In Bezug auf die mit einem Resist beschichteten metallischen Substrate wird die Aufgabe gemäß dem kennzeichnenden Merkmal des Anspruchs 1 gelöst, im Bezug auf das Verfahren gemäß den kennzeichnenden Merkmalen des Anspruchs 13.

Gegenüber dem Stand der Technik hat die erfindungsgemäße Beschichtung den Vorteil, daß das der Haftvermittlung zwischen Resist und Substrat dienende Material nur an der Stelle anzutreffen ist, wo es auch benötigt wird, nämlich an der Grenzschicht von Resistmaterial und Substrat. Das Volumen des strahlungsempfindlichen Resistmaterials selbst ist nicht mit strahlungsunempfindichen Fremdbestandteilen durchsetzt, so daß in der Schicht der Kontrast zwischen bestrahltem und unbestrahltem reinen Resistmaterial optimal ausgenutzt werden kann.

In der DE 24 48 821 wird die Verbesserung der Haftung mittels einer thermoplastischen, photopolymerisierbaren Schicht für Schichtträger aus Kupfer beschrieben. Hierzu werden Haftschichten auf Mercaptoalkansäure-Basis verwendet. Diese Haftschichten haben jedoch den Nachteil, daß sie nach der Bestrahlung selektiv in den entwickelten Bereichen mit einem zusätzlichen Prozeßschritt entfernt werden müssen. Die Haftschichten der vorliegenden Erfindung sind aber so dünn (monomolekular), daß die auf die Bestrahlung und Entwicklung folgende galvanische Abformung problemlos gestartet werden kann, ohne daß Rückstände der Haftschicht vorher in einem zusätzlichen Prozeßschritt entfernt werden müßten.

Monomolekulare Schichten, welche mit Strahlung strukturierbar sind, werden in der DE 27 28 352 beschrieben. Eine Differenzierung zwischen bestrahltem und unbestrahltem Bereich erfolgt hierbei so, saß einzelne Moleküle der monomolekularen Schicht in den bestrahlten Bereichen miteinander reagieren. Derartige Moleküle sind aber als Haftvermittlerschicht nicht geeignet. In der vorliegenden Erfindung reagieren hingegen die Moleküle der monomolekularen Schicht mit den Molekülen aus dem darüberliegenden Resist.

Die Herstellung der monomolekularen Schicht aus bifunktionellen organischen Molekülen erfolgt auf einfache Weise. Die organische Verbindung mit den beiden endständigen funktionellen Gruppen wird in einem geeigneten Lösungsmittel gelöst. In der Lösung wird sodann das Substrat behandelt. Die eine der beiden funktionellen Gruppen reagiert dabei selektiv mit der Oberfläche des Substrats. Da die beiden funktionellen Gruppen über einen Spacer räumlich voneinander getrennt sind, stellen solche Moleküle sogenannte "selbstorganisierende Strukturen" dar, welche sich als monomolekularen Schicht auf der Oberfläche des Metalls ausbilden können.

Nach der Behandlung wird das Substrat gewaschen, am besten mit dem verwendeten Lösungsmittel, und sodann getrocknet. Das solchermaßen vorbehandelte, mit einer monomolekularen Schicht überzogene Substrat wird dann nach an sich bekannten Verfahren mit einem Gießharz aus Resistmaterial beschichtet.

Wie weiter oben bereits ausgeführt, bildet die Trimethoxysilyl-Gruppe einen ausgezeichneten Vertreter für eine selektiv mit Oberflächen von unendlen Metallen oder Halbleitern reagierende funktionelle Gruppe. Die Anheftung an das Substrat erfolgt über die Ausbildung einer Esterbindung mit den aus der Oberflächenoxidschicht des Substrats unter Einwirkung von Wasser gebildeten OH-Gruppen. Vor der Veresterung wird die Trimethoxysilylgruppe zunächst spontan unter Abspaltung von Methanol zur Silanol-Gruppe hydrolysiert, welche dann über eine Kondensationsreaktion mit der hydrolysierten Oxidschicht der Metall-Oberfläche die Veresterung zur Siloxanverbindung ergibt. Gleichzeitig können zwei auf der Metalloberfläche benachbarte Silanolgruppen einer Autokondensation unterliegen. Als Folge bildet sich dann auf den Metall-oder Halbleiteroberflächen ein gebundenes Netzwerk aus Siloxanen aus, welches dann eine Selbstorganisation der auf der Metalloberfläche ausgebildeten monomolekularen Schicht aus den linearen Siloxanmolekülen begünstigen kann. Gleichermaßen geeignet zur selektiven Anbindung an Oberflächen von unedlen Metallen und Halbleitern sind alle Silyl-Gruppen, die am Silicium-Atom mit mindestens einer Alkoxygruppe oder einem Halogen (Cl, Br, J) substituiert sind.

Im Falle von Edelmetall- und Kupfersubstraten, welche keine Oberflächenoxidschichten ausbilden, ist die Trimethoxysilyl-Gruppe bzw. die nach Hydrolyse enstandene Silanolgruppe zur Bindung an die Metalloberfläche ungeeignet. Aus der Literatur ist jedoch bekannt (J. Am. Chem. Soc. Vol. 112, No. 11 1990, 4301-4306), daß Alkanthiole auf Gold selbstorganisierende Moleküle darstellen, die im Sinne einer Adsorption als dichtgepackte monomolekularen Schicht chemisch an die Goldoberfläche gebunden werden und eine sehr gute Haftung ergeben. Verbindungen ähnlichen Charakters stellen thiophenolterminierte Oligoimide (W.S.V. Kwan, L. Atanasowa, L.L. Miller, Langmuir, 7, 1419 (1991)) und organische Disulfide (R.G. Nuzzo, F.A. Fusco, D.L. Allara, J.Am. Chem. Soc. 109, 2359 (1987)) dar. Da die monomolekularen Schichten spontan aus Lösung bzw. aus der Gasphase adsorbieren, ist eine Herstellung von mit für die vorliegende Erfindung geeigneten bifunktionellen Haftvermittler-monomolekularen Schichten beschichteten Substraten relativ einfach und erfolgt z.B. ebenfalls mittels Inkubation in einer entsprechenden Lösung. Thiol- bzw.Thiolphenyl-Gruppen stellen mithin hochreaktive funktionelle Gruppen für die selektive Bindung von Haftvermittlersubstanzen an die Oberflächen von Substraten aus Edelmetallen, insbesondere Gold und Kupfer, dar.

Die Auswahl der selektiven funktionellen Gruppen für die chemische Bindung an den Resist hängt naturgemäß von der chemischen Struktur des Resists ab. Bestens geeignet sind immer solche funktionellen Gruppen, welche auch für die Quervernetzung der das Polymer aufbauenden Monomereinheiten verantwortlich sind. Im Falle des am meisten als Resist eingesetzten Poly(methylmethacrylat)s (PMMA) ist dies die Methacrylatgruppe (2-Methylpropen-(1)-Carboxyl-(3)-Rest). Die kovalente chemische Bindung an den Resist erfolgt dann nach Aufbringen des Gießharzes (welches im Falle von PMMA aus einer Lösung von vorpolymerisiertem PMMA in Methylmethacrylat (MMA) besteht) auf die bereits mit einer monomolekularen Schicht aus Haftvermittlersubstanz bedeckte Metalloberfläche zusammen mit der Quervernetzungsreaktion (Polymerisation) des Gießharzes auf dem Substrat. Das Auftragen des Gießharzes auf die mit der monomolekularen Haftvermittlerschicht bedeckte Substratoberfläche kann nach sämtlichen gängigen Methoden gemäß dem Stand der Technik erfolgen, z.B. durch Aufschleudern, Aufgießen oder Aufpressen. Die chemische Verknüpfung zwischen der funktionellen Gruppe des Haftvermittlermaterials und dem Resistmaterial erfolgt dann während der Polymerisation des Methylmethacrylates im Sinne einer Copolymerisation.

Es können erfindungsgemäß auch andere als die dem Monomer des Resistmaterials zugrundeliegenden reaktiven Gruppen auf der dem Resist zugewandten Seite der linearen Haftvermittlersubstanz zur Anwendung kommen. Diese reagieren dann mit dem Resistmaterial im Sinne einer polymer-analogen Reaktion. Im Falle von Polymeren mit Estergruppen in Haupt- oder Seitenkette (z.B. PMMA) als Resistmaterial eignet sich hierfür insbesondere die Amino-Gruppe.

Durch geeignete Wahl der für die kovalente Bindung an den Resist verantwortlichen funktionellen Gruppe kann die Haftvermittlersubstanz optimal an andere, für Röntgenlithographie geeignete Resistmaterialien angepaßt werden, z.B. Polyoxymethylen (POM) oder Polyalkensulfon (PASO).

In den Fällen, wo die funktionellen endständigen Gruppen der Haftvermittlersubstanz den funktionellen hochreaktiven Gruppen der Monomereinheiten des Resistmaterials entsprechen, z.B. ein endständiger Methacrylat-Rest bei Verwendung von PMMA als Resistmaterial, oder andere im Sinne einer Polymerisation selbst miteinander reagierende hochreaktive Gruppen sind, ist die chemische Bindung an das Resistmaterial weniger gut ausgeprägt. Der Grund ist darin zu suchen, daß die reaktiven Gruppen der Haftvermittlersubstanz in der monomolekularen Schicht infolge Selbstorganisation der Moleküle unmittelbar benachbart angeordnet sind, so daß sie bevorzugt selbt miteinander reagieren bzw. polymerisieren. Um dies zu verhindern, wird der eigentlichen Haftvermittlersubstanz eine gleichermaßen konstituierte zweite Substanz beigemischt, mit gleicher funktioneller Gruppe zur selektiven Anbindung an die Substratoberfläche aber einer anderen, dem Resist zugewandten endständigen Gruppe, welche nicht zur Eigenreaktion befähigt ist. Diese zweite Substanz wird der Haftvermittlersubstanz in einem Verhältnis (bezogen auf das Gewicht) von vorzugsweise 1:1 bis 10:1 zugesetzt. Damit wird erreicht, daß die zur Eigenreaktion befähigten noch hochreaktiven Gruppen auf der dem Resist zugewandten Seite der monomolekularen Schicht seitlich voneinander so weit beabstandet sind, daß sie untereinander keine kovalenten chemischen Bindungen mehr ausbilden können. Dies bedeutet, daß bei einem Verhältnis von "Abstandshaltersubstanz" zu eigentlicher Haftvermittlersubstanz von 1:1 nur jede zweite endständige Gruppe der monomolekularen Schicht bei der Polymerisation des Resists mit diesem im Sinne einer Polymerisation bzw. Copolymerisation reagieren kann, bei einem Verhältnis von 10:1 nur jede 11. Gruppe.

Im allgemeinen sind erfindungsgemäß die beiden funktionellen Gruppen der linearen Haftvermittlersubstanz über einen Spacer voneinander beabstandet. Dieser hat unter anderem die Aufgabe, bei der Selbstorganisation der die monomolekularen Schicht aufbauenden bifunktionellen Moleküle zu helfen. Als Spacer eignen sich alle linearen aliphatischen und aromatischen Kohlenwasserstoff-, Poly(ester)-, Poly(ether)-, Poly(amid)-, Poly(imid)-Ketten unterschiedlicher Länge, sowie die Kombination verschiedener Typen. Bevorzugte Repräsentanten für den Spacer stellen der Trimethylen-Rest und der Phenylen-Rest dar.

Typische Vertreter der erfindungsgemäß eingesetzten Haftvermittlersubstanzen sind z.B.
Methacryloyloxypropyltrimethoxysilan (MEMO)(1),
Methacryloyloxytrichlorsilan (2),
3-Aminopropyltrimethoxysilan (3),
p-Aminophenyltrimethoxysilan (4),
4-Aminothiophenol (5),
4-Methacrylamidothiophenol (6),
3-Aminopropyltrichlorsilan (7),
4-(Trimethoxysilyl)phenol (8),
3-Aminopropyldialkoxyalkylsilan (9),
3-Aminopropylalkoxydialkylsilan (10),
3-(4-Methoxyphenyl)propylmethyldichlorsilan (11)
und ähnliche.

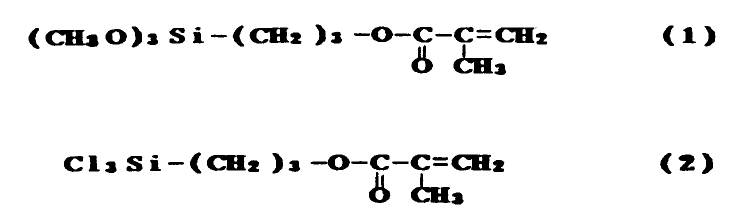

(CH₃O)₃Si-(CH₂)₃-NH₂ (3)

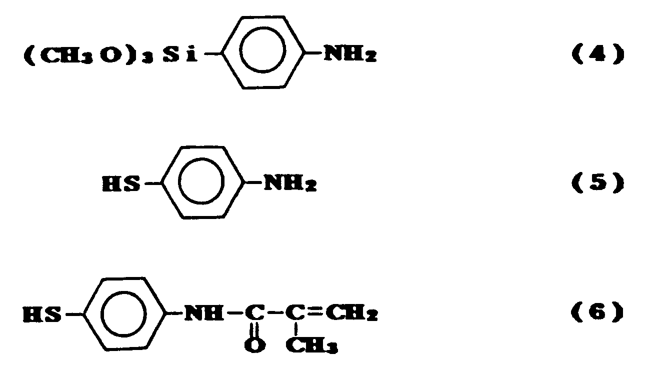

Cl₃Si-(CH₂)₃-NH₂ (7)

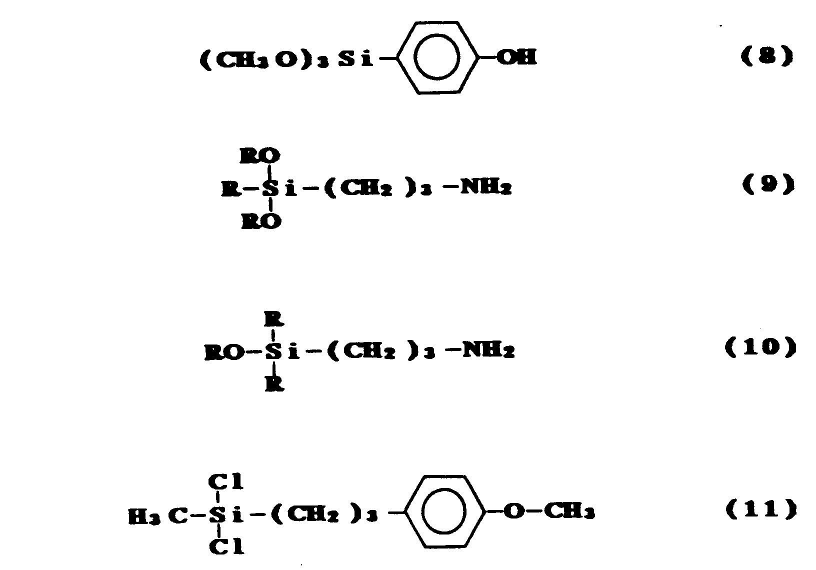

- R:: Unabhängig voneinander jeweils Alkylgruppen
Bei dem gewöhnlich als Resistmaterial eingesetzten PMMA handelt es sich um einen positiven Resist, das heißt, der bestrahlte Bereich des vernetzten Polymers wird entwickelt, wodurch die Löslichkeit in diesem Bereich drastisch ansteigt. Nach Herauslösen des im bestrahlten Bereich vorliegenden löslichen Resistmaterials verbleiben die erwünschten Mikrostrukturen im unbestrahlten Bereich. Stört die in den Bereichen des herausgelösten Resistmaterials noch vorhandene monomolekulare Haftvermittlerschicht die nachfolgenden Galvanikprozeduren, so kann die monomolekularen Schicht dort durch betreffende Naß- bzw. Trockenätzverfahren gemaß dem Stand der Technik entfernt werden. In den meisten Fällen ist die monomolekularen Schicht der Haftvermittlersubstanz aber genügend dünn und glatt strukturiert, so daß sie bei dem nachfolgenden Galvanikprozeß nicht störend in Erscheinung tritt.

Eine andere Art von Resistmaterial bilden die sogenannten negativen Resists, das heißt, die Vernetzungsreaktion des zunächst als Gießharz aufgetragenen Polymermaterials, und damit seine Strukturierung, erfolgt unter Einwirkung von Strahlung. In den unbestrahlten Bereichen bleibt dann das Polymer als Gießharz von den bestrahlten, strukturierten Bereichen herauslösbar. Die Anbindung der dem Resist zugewandten funktionellen Gruppe der Haftvermittlersubstanz an den Resist, welche ja zusammen mit der Quervernetzungreaktion ablaufen soll, wird also ebenfalls erst unter Einwirkung der Strahlung erzielt.

Als negativer Resist kann z.B. Novolak, ein Phenoplast, also ein Kondensationsprodukt aus Phenol und Formaldehyd eingesetzt werden. Solche Kondensationsprodukte sind in Alkohol löslich und schmelzbar, jedoch nicht selbstvernetzend und können daher z.B. aus der Schmelze gepreßt werden. Nach Zugabe eines Vernetzers, wie z.B. Hexa(methoxymethyl)melamin und eines Photosensibilisators, z.B. Triphenylsulfoniumhexafluoroantimonat, lassen sich die Novolake durch Bestrahlung aushärten. Wird nun ein Novolak einer Bestrahlung durch eine Maske unterworfen, vernetzt er in den bestrahlten Bereichen und wird dadurch unlöslich. Die Anbindung des vernetzenden Resists an die Haftvermittlerschicht, z.B. (H₃CO)₃Si-(C₆H₄)-OH, einer phenolischen, dem Resist zugewandten funktionellen Gruppe, wird dabei gleichzeitig mit der Vernetzung des Harzes erzielt.

Die Erfindung wird im folgenden anhand einiger repräsentativer Beispiele näher erläutert:

### Beispiel 1

Ein Gießharz, bestehend aus 70 Gew.-% Methylmethacrylat und 30 Gew.-% vorpolymerisiertem PMMA wurde mit 5 Gew.-% einer Lösung von Benzoylperoxid (BPO, 6 Gew.-%) in Diisobutylphthalat und 0,5 Gew.-% BPO (bezogen auf das MMA und vorpolymerisierte PMMA) intensiv durchmischt. Die so erhaltene Mischung wurde mittels des Gieß-Verfahrens auf einen Silicium-Wafer mit einem Überzug aus Gold aufgetragen.

Zur Untersuchung der Haftfestigkeit wurde die erhaltene Schichtkombination mit Ultraschall über einen Zeitraum von 12 min beschallt. Die Haftung wurde wie folgt beurteilt:
Nach einer ersten kurzen Ultraschallbehandlung von 2 min konnte die Goldschicht mit der PMMA-Schicht als ganzes vom Silicium-Wafer getrennt werden. Danach erfolgte eine 10 minütige Ultraschallbehandlung. Man konnte deutlich ein Ablösen der Goldschicht vom PMMA bis auf ca. zehn Flächenprozent feststellen.

### Beispiel 2

Ein Silicium-Wafer mit Goldoberfläche wurde zur Aufbringung der monomolekularen Haftschicht in eine Losung von 4-Aminothiophenol (1 mmol) in Ethanol bei Raumtemperatur über einen Zeitraum von 2 Tagen inkubiert. Danach wurde das Substrat mit Ethanol gewaschen und im Luftstrom bei 60-70°C getrocknet.

Das so vorbehandelte Substrat wurde, wie in Beispiel 1 beschrieben, beschichtet.
Zur Untersuchung der Haftfestigkeit wurde das erhaltene beschichtete Substrat mit Ultraschall über einen Zeitraum von 12 min beschallt. Die Haftfestigkeit wurde wie folgt beurteilt:
Nach einer ersten kurzen Ultraschallbehandlung von 2 min konnte die Goldschicht mit der PMMA-Schicht als ganzes vom Silicium-Wafer getrennt werden. Danach erfolgte eine 10 minütige Ultraschallbehandlung. Die Goldschicht blieb mit dem PMMA verbunden.

Außerdem wurde der Haftvermittler noch im LIGA-Prozeß getestet. Dabei wurden PMMA-Schichten unterschiedlicher Dicke unter Verwendung des Haftvermittlers nach dem obengenannten Verfahren auf einen goldbeschichteten Silicium-Wafer aufgebracht und unschließend einer Bestrahlung mit Synchrotronstrahlung durch eine Röntgenmaske unterzogen. Die Haftfestigkeit wurde anhand der Standfestigkeit von 20 x 20 µm² großen Säulen beurteilt. Bei einer Resistdicke von 40 µm blieben 100 %, bei 60 µm blieben 80 % und bei einer Resistdicke von 120 µm blieben 50 % der Säulen stehen. Ohne Haftvermittler löste sich die PMMA-Schicht schon vor der Bestrahlung.

### Beispiel 3

Ein Gießharz, wie in Beispiel 1 beschrieben, wird mittels des Gieß-Verfahrens auf einen Silicium-Wafer mit einem Überzug aus Cu aufgetragen.

Die Haftfestigkeit der erhaltenen Schichtkombination wurde mittels Beschallung mit Ultraschall über einen Zeitraum von 10 min bestimmt. Nach der Beschallung zeigte die Schichtkombination folgende Eigenschaften:

Die PMMA-Schicht löst sich bereits während der Beschallung von dem Kupfer-Substrat.

### Beispiel 4

Ein Silicium-Wafer mit Kupferoberfläche wird, wie in Beispiel 2 beschrieben, mit einer monomolekularen Schicht aus 4-Aminothiophenol beschichtet. Die Zusammensetzung und die Aufbringung des Gießharzes erfolgt wie in Beispiel 1 beschrieben. Die Haftfestigkeit der erhaltenen Schichtkombination wurde mittels Beschallung mit Ultraschall über einen Zeitraum von 10 min bestimmt. Nach der Beschallung zeigte die Schichtkombination folgende Eigenschaften:

Die PMMA-Schicht löste sich während der Beschallung nicht vom Kupfer-Substrat. Sie konnte auch nicht von den Rändern mechanisch abgelöst werden.

### Beispiel 5:

Dem in Beispiel 1 beschriebenen Gießharz wurden 5 Gew.-% Methacryloyloxypropyltrimethoxysilan (MEMO) bezogen auf die Gießharzmischung aus MMA und vorpolymerisiertem PMMA) zugefügt und intensiv durchmischt. Die erhaltene Mischung wurde mittels des Gieß-Verfahrens auf einen Silicium-Wafer aufgetragen.

Die Haftfestigkeit der erhaltenen Schichtkombination wurde mittels Beschallung mit Ultraschall über einen Zeitraum von 10 min bestimmt. Nach der Beschallung zeigte die Schichtkombination folgende Eigenschaften: Die PMMA-Schicht ließ sich leicht mit einer Pinzette vom Substrat lösen bzw. blätterte bei Berührung ab.

### Beispiel 6

Es wurde eine Mischung aus Acetoxypropyltrimethoxysilan und MEMO mit einem Volumenverhältnis von 10:1 bereitet. In einer Lösung dieser Mischung (1 Vol.-%) in Tetrachlorkohlenstoff wurde der Silicium-Wafer über einen Zeitraum von drei Stunden bei Raumtemperatur inkubiert. Danach wurde mit Tetrachlorkohlenstoff gewaschen und im Luftstrom getrocknet. Die Zusammensetzung und die Aufbringung des Gießharzes erfolgten, wie in Beispiel 1 beschrieben.

Die Haftfestigkeit der erhaltenen Schichtkombination wurde mittels Beschallung mit Ultraschall über einen Zeitraum von 10 min bestimmt. Nach der Beschallung zeigte die Schichtkombination folgende Eigenschaften:
Die PMMA-Schicht ließ sich leicht mechanisch in großen Stücken ablösen.

### Beispiel 7

Ein Silicium-Wafer wurde in einer 1-volumenprozentigen Lösung von Trimethoxysilylpropylamin in Chloroform über einen Zeitraum von 3 Stunden bei Raumtemperatur inkubiert. Danach wurde mit Chloroform nachgewaschen und im Luftstrom bei 60-70°C getrocknet.

Die Zusammensetzung und die Aufbringung des Gießharzes erfolgten, wie in Beispiel 1 beschrieben. Die Haftfestigkeit der erhaltenen Schichtkombination wurde mittels Beschallung mit Ultraschall über einen Zeitraum von 10 min bestimmt. Nach der Beschallung zeigte die Schichtkombination folgende Eigenschaften:
Die PMMA-Schicht blieb haften und konnte auch von den Rändern her mechanisch nicht abgelöst werden.

### Beispiel 8:

Ein Gießharz, wie in Beispiel 1 beschrieben, das zusätzlich 5 Gew.-% MEMO enthielt wurde mittels des Gieß-Verfahrens auf einen Silicium-Wafer mit einem Überzug aus Aluminium aufgetragen.

Die Haftfestigkeit der erhaltenen Schichtkombination wurde mittels Beschallung mit Ultraschall über einen Zeitraum vom 10 min bestimmt. Nach der Beschallung zeigte die Schichtkombination folgende Eigenschaften:
Die PMMA-Schicht löste sich bei leichter Berührung als ganze Schicht vom Aluminium-Substrat.

### Beispiel 9:

Ein Silicium-Wafer mit Aluminiumoberfläche wurde wie in Beispiel 7 beschrieben mit einer monomolekularen Schicht aus Trimethoxypropylsilylamin beschichtet. Die Zusammensetzung und die Aufbringung des Gießharzes erfolgten wie in Beispiel 1 beschrieben.

Die Haftfestigkeit der erhaltenen Schichtkombination wurde mittels Beschallung mit Ultraschall über einen Zeitraum von 10 min bestimmt. Nach der Beschallung zeigte die Schichtkombination folgende Eigenschaften:
Die PMMA-Schicht haftete im Vergleich zu Beispiel 8 deutlich besser.

## Patentansprüche

1. Mit einem Resist beschichtetes Metall- oder Halbleitersubstrat zur Verwendung bei der Herstellung von Formen für mikromechanische Strukturen mittels Röntgentiefenlithographie` dadurch gekennzeichnet, daß zwischen Substrat und Resist eine monomolekulare Haftschicht aus bifunktionellen, linearen, selbstorganisierenden organischen Molekülen mit endständigen funktionellen Gruppen angeordnet ist, deren eine Gruppe sich spezifisch an die Substratoberfläche bindet, während die andere Gruppe kovalent an das Resistmaterial gebunden ist.

2. Beschichtetes Substrat nach Anspruch 1, dadurch gekennzeichnet, daß das Substrat ein an der Luft zur Oberflächenoxidation neigendes unedles Metall oder ein Halbleiter, ein Edelmetall, vorzugsweise Au oder Ag, oder Kupfer ist oder ein mit einer Schicht aus Edelmetall oder Kupfer überzogenes anderes Material.

3. Beschichtetes Substrat nach den Ansprüchen 1 und 2, dadurch gekennzeichnet, daß die beiden endständigen funktionellen Gruppen der organischen Moleküle durch einen Spacer voneinander getrennt sind, welcher eine lineare aliphatische oder aromatische Kette ist, ausgewählt aus der Gruppe Kohlenwasserstoffketten, vorzugsweise eine Trimethylen- oder Phenylen-Gruppe, Poly(ester)-, Poly(ether)-, Poly(amid)-, Poly(imid)-Ketten unterschiedlicher Länge oder eine Kombination dieser Vertreter.

4. Beschichtetes Substrat nach jedem der Ansprüche 1-3, dadurch gekennzeichnet, daß der Resist ein positiver Resist ist, vorzugsweise aus Poly(methylmethacrylat) (PMMA).

5. Beschichtetes Substrat nach jedem der Ansprüche 1-3, dadurch gekennzeichnet, daß der Resist ein negativer Resist ist, vorzugusweise ein Novolak.

6. Verfahren zur Herstellung eines mit einem Resist beschichteten Metall- oder Halbleitersubstrats nach einem der Ansprüche 1 - 5, dadurch gekennzeichnet, daß das Substrat mit einer Lösung einer zur Selbstorganisation befähigten organischen Verbindung mit zwei endstandigen funktionellen Gruppen, wovon eine spezifisch zur Ausbildung einer stabilen Bindung an die Substratoberfläche, die andere zur Ausbildung einer kovalenten chemischen Bindung mit dem Resist befähigt ist, behandelt wird, vorzugsweise über einen Zeitraum von 2-4 Stunden, sodann nach Reaktion der Substratoberfläche mit der funktionellen Gruppe aus der Lösung entnommen, gewaschen und danach getrocknet wird, und auf die so vorbehandelte Substratoberfläche nach an sich bekannten Verfahren auf das Resistmaterial aufgebracht und danach unter Zufuhr von Energie quervernetzt und/oder ausgehärtet wird.

7. Verfahren nach Anspruch 6, dadurch gekennzeichnet, daß als Substrat ein unedles Metall oder ein Halbleiter und für die Bindung mit der Substratoberfläche eine organische Verbindung mit einer Silylgruppe, in welcher an das Silicium-Atom mindestens eine Alkoxy-Gruppe oder ein Halogen-Atom aus der Gruppe Cl, Br, J gebunden ist, verwendet wird.

8. Verfahren nach Anspruch 6, dadurch gekennzeichnet, daß als Substrat ein Edelmetall, vorzugsweise Gold oder Silber, oder Kupfer oder ein mit einem Überzug aus einem dieser Elemente versehenes anderes Substrat und für die Reaktion mit der Substratoberfläche eine organische Verbindung mit einer Thiolgruppe verwendet werden, und die Behandlung des Substrats in der Lösung der organischen Verbindung über einen Zeitraum von 1-3 Tagen erfolgt.

9. Verfahren nach jedem der Ansprüche 6-8, dadurch gekennzeichnet, daß als funktionelle Gruppe zur Bindung an das Resist eine bei der Quervernetzung des Gießharzes mit diesem eine chemische Bindung eingehende Gruppe verwendet wird.

10. Verfahren nach jedem der Ansprüche 6-9, dadurch gekennzeichnet, daß bei Verwendung einer organischen Verbindung mit einer unter den Reaktionsbedingungen zur Quervernetzung des Resistmaterials zur Polymerisation neigenden funktionellen Gruppe der Lösung dieser organischen Verbindung vor Behandlung des Substrats eine weitere unter diesen Reaktionsbedingungen nicht zur Polymerisation befähigte organische Verbindung in der ein-bis zehnfachen, vorzugsweise 3-6-fachen Gewichtsmenge der ersten organischen Verbindung zugesetzt wird.
